(19) Europäisches Patentamt

European Patent Office

Office européen des brevets

(11) **EP 1 119 910 B1**

(12) **EUROPEAN PATENT SPECIFICATION**

(45) Date of publication and mention
of the grant of the patent:
**14.01.2004 Bulletin 2004/03**

(51) Int Cl.[7]: **H03H 17/02**

(86) International application number:
**PCT/SG1998/000082**

(21) Application number: **98950602.7**

(22) Date of filing: **13.10.1998**

(87) International publication number:
**WO 2000/022729 (20.04.2000 Gazette 2000/16)**

(54) **AREA EFFICIENT REALIZATION OF COEFFICIENT ARCHITECTURE FOR BIT-SERIAL FIR, IIR FILTERS AND COMBINATIONAL/SEQUENTIAL LOGIC STRUCTURE WITH ZERO LATENCY CLOCK OUTPUT**

FLÄCHENEFFIZIENTE HERSTELLUNG VON KOEFFIZIENT-ARCHITEKTUR FÜR BIT-SERIELLE FIR, IIR FILTER UND KOMBINATORISCHE/SEQUENTIELLE LOGISCHE STRUKTUR OHNE LATENZ

REALISATION A RENDEMENT SURFACIQUE D'UNE ARCHITECTURE DE COEFFICIENTS POUR FILTRES EN SERIE PAR BIT, RIF, RII ET STRUCTURE LOGIQUE COMBINATOIRE/SEQUENTIELLE A SORTIE D'HORLOGE A RETARD NUL

(84) Designated Contracting States:
**DE FR GB IT**

(43) Date of publication of application:
**01.08.2001 Bulletin 2001/31**

(73) Proprietors:
• **STMicroelectronics Pte Ltd.**
 **Singapore 569508 (SG)**
• **STMicroelectronics Limited**
 **Uttar Pradesh (IN)**

(72) Inventors:
• **MALIK, Rakesh-STMicroelectronics Limited**
 **Uttar Pradesh (IN)**
• **GOEL, Puneet**
 **Punjab (IN)**

(74) Representative: **Cerbaro, Elena, Dr. et al**
 **STUDIO TORTA S.r.l.,**
 **Via Viotti, 9**
 **10121 Torino (IT)**

(56) References cited:
**WO-A-94/23493**

• **DAWOOD ALAM ET AL: "VLSI IMPLEMENTATION OF A NEW BIT-LEVEL PIPELINED ARCHITECTURE FOR 2-D ALLPASS DIGITAL FILTERS" 1995 IEEE INTERNATIONAL SYMPOSIUM ON CIRCUITS AND SYSTEMS (ISCAS), SEATTLE, APR. 30 - MAY 3, 1995, vol. 1, 30 April 1995, pages 724-727, XP000583315 INSTITUTE OF ELECTRICAL AND ELECTRONICS ENGINEERS**
• **K. MANIVANNAN ET AL.: "Minimal Multiplier Realization of 2-D All-Pass Digital Filters" IEEE TRANSACTIONS ON CIRCUITS AND SYSTEMS., vol. 35, no. 4, April 1988, pages 480-484, XP002104516 NEW YORK US**
• **DUNCAN P. ET AL: 'Strategies for Design Automation of High Speed Digital Filters' JOURNAL OF VLSI SIGNAL PROCESSING no. 9, 1995, DORDRECHT, NL, pages 105 - 118**

## Description

### FIELD OF INVENTION

The invention relates to area efficient realization of coefficient block [A] or achitecture [A] with hardware sharing techniques and optimizations applied to this block. The coefficient block [A] is connected to coefficient lines (CLin_0, CLin_1.....CLin_n and BLin_0, BLin_1,....BLin_n,) for performing filtering operation or a mathematical computing operation with optimization in hardware and provides a zero latency output, i.e. an output with no dock delay. The invention also gives the area minimal, realization of digital filters based on coefficient block[A], when operated in bit serial fashion. The optimization techniques and structure of the present invention are good for bit-serial digital filters typically a finite impulse response(FIR) filter, infinite impulse response filter(IIR) and for other filters and applications based on combinational logic consisting of delay element(T), multiplier(M), serial adder(SA) and serial subtractor (SS).

### Brief description of the accompanying drawings

In the accompanying drawings:

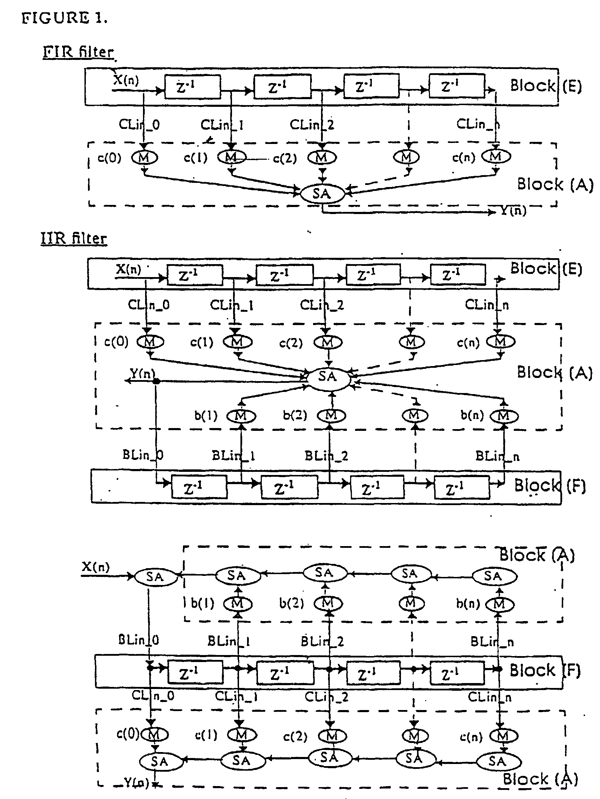

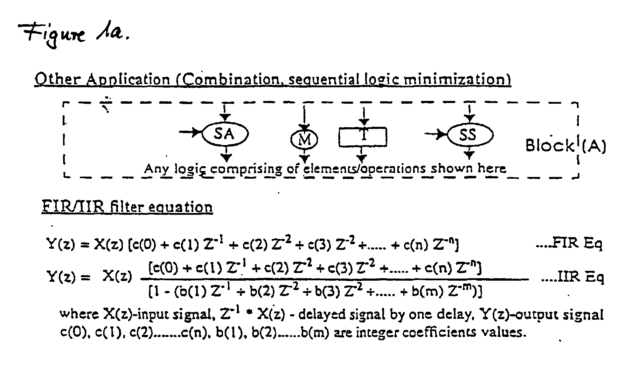

Figure 1 shows the field of invention, applications of the'device
Figure 2 shows the symbol of components used in the device.
Figure 3 shows the description of components used in the device.
Figure 4 shows the bit serial FIR filter implementations
Figure 5 shows an example of FIR filter.
Figure 6 shows one of the known minimization technique due to symmetry of coefficient.
Figure 7 shows the structure of prior/known implementation technique for coefficient block.
Figure 8 shows the generalized structure of prior/known implementation technique of coefficient block.
Figure 9 shows the minimization technique involved in FIR filter.
Figure 10 shows the generalized structure of the minimization technique involved in FIR filter.
Figure 11 shows the minimized structure of this example FIR filter, of the present invention.
Figure 12 shows the generalized opimized structure of the present invention.
Figure 13 shows the other advantage of the structure i.e getting the parallel output directly, of the present invention.
Figure 14 shows an implementation flow of a first filter equation.
Figure 15 shows an implementation flow of a second filter equation.

### Details of Elements/symbol used in the description

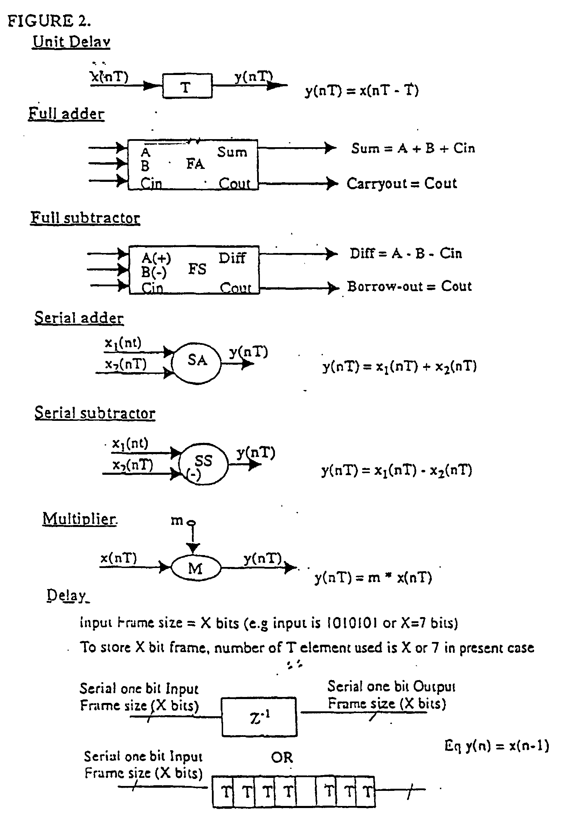

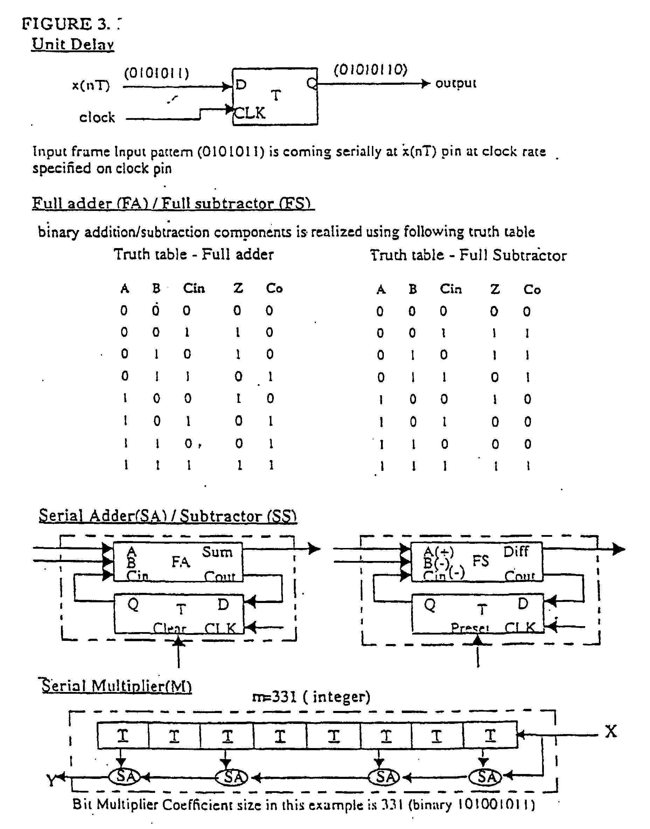

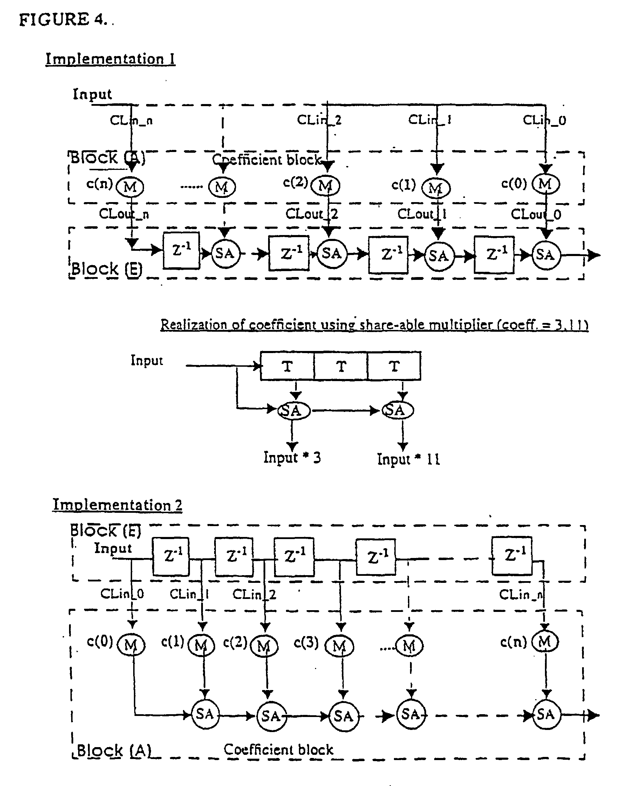

The basic components symbol used in design are shown in "Figure 2" of the drawings. In addition, explanation and usages of the device are done in the text below and depicted in "Figure 3" and "Figure 4" of the drawings.

### Unit delay (T)

It is one bit delay element. It also performs function of a multiplier by a factor of 2. [e.g. For the serial input frame (0101011 in binary or 43 in integer representation), the output of this block is (01010110 in binary or 86 in integer representation). This element is usually a Flip-flop (D Flip-flop, J-K Flip-flop etc.).

### Full adder (FA)

It performs binary addition. The inputs to this element are A, B, Cin (Carryin) while the outputs are Z and Cout (Carryout). The truth table for full adder functionality is shown in "Figure 3" of the drawings.

### Full subtractor (FS)

It performs binary subtraction. The inputs to this element are A, B, Cin (Carryin) while the outputs are Z and Cout (Carryout). The truth table for full subtractor functionality is shown in "Figure 3" of the drawings.

### Serial adder (SA) and Serial Subtractor (SS)

It performs addition/subtraction of two serial frame, x1(nT), x2(nT) to generate output y(nT) represented as x1(nT)+x2(nT) or x1(nT)-x2(nT). The serial adder (or subtractor) is implemented using a full adder (or subtractor) with a Flip-Flop as shown in "Figure 3" of the drawings. The output Cout of a full adder/subtractor is delayed using the unit delay element [T] and is applied to Cin line of the full adder/subtractor. This enables the full adder/subtractor and the unit delay element [T] together to function as serial adder (SA/SS), where A, B are the inputs to this element and Z is the output. (e.g of serial addition is as follows, if x1(nT) = 0110 (6 in integer) and x2(nT) = 0111 (7 in integer). Then y (nT) = 01101 (13 in integer representation).

### Serial Multiplier (M)

It multiplies two serial input frame X(nT) and m. The output is function represented as Y(nT) = X(nT) * m. A serial coefficient multiplier(M) can be implemented by shift register using unit delay elements [T], and adder elements [SA] (One shift means multiply by factor of 2). As shown in "Figure 3" of the drawings, the multiplier is formed by adding the outputs corresponding to ones in the binary representation of the coefficient.

### Delay ($Z^{-1}$)

Delay by one frame of data is done by shift register (series of Flip-flops (T) connected to store and shift the input frame). The number of Unit delay (T) in one delay element is equal to the frame size of the input.

### PRIOR ART OR EXISTING IMPLEMENTATION OF FILTER

The following description discusses the elements used for implementation of architecture and the existing implementations for digital filters. The proposed minimization is extendable to other applications such as Digital Signal Processing field and Digital designs.

From here onwards, all the illustration will be done with FIR filter which is extendable to other filters as described earlier. "Figure 4"shows the existing structure of bit serial FIR filter with coefficient lines CLin_0, CLin_1,..... CLin_n and the coefficient block [A] having the coefficients c(0), c(1), c(2),.....c(n). The coefficient block is connected to delay elements [$Z^{-1}$] and serial adders [SA] to form filter structure.

A method to incorporate the delay fine into the calculation process has been used previously, see P. Duncan et al. "Strategies for Design Automation of High Speed Digital Filters", J. of VLSI Signal Processing, Dordrecht, 1995, no. 9, pages 105 to 118, in particular figures 2, 7, and 10.

Stating the FIR filter equation in time and frequency domain

$$Y(n) = c(0)\ X(n) + c(1)\ X(n-1) + c(2)\ X(n-2) +.....c(n)\ X(0)$$

$$Y(z) = X(z)\ [c(0) + c(1)\ Z^{-1} + c(2)\ Z^{-2} + c(3)\ Z^{-3} + c(4)\ Z^{-4} + c(5)\ Z^{-5} + c(6)$$

$$Z^{-6} +.................+c(n)Z^{-n}]$$

where X, Y are the input and output respectively and c(0), c(1).....c(n) represent the coefficients value which defines the characteristics of the filter and each delay [$Z^{-1}$] block represents sample delay of one. The filter equation can be implemented in two ways as shown in "Figure 4" of the drawings,

In implementation 1, coefficient lines. CLin_0, CLin_1,......CLin_n are common and connected to input X[n]. The output lines CLout_0, CLout_1,.....CLout_n are connected to a delay block [E], consisting of delay elements [$Z^{-1}$] and serial adders [SA]. The structure makes easy realization of share-able multiplier in the coefficient block [A]. An example of share-able multiplier with coefficient values 3,11 is illustrated in "Figure 4". The realization of these coefficient separately would require four unit delay elements and threee serial adders. By virtue of coefficient lines CLin_0, CLin_1,... being common, the hardware is realized using three unit delay elements and two serial adders. Another feature of the structure is that the structure inherently requires more storage area, represented by [$Z^{-1}$], as compared to implementation2, since the storage is done after the multiplication. For input frame of n bit and coefficient of size m bit, the storage area of each delay element [$Z^{-1}$] is (m+n). The total storage space of the delay elements is equal to (m+n) * (number of coefficients -1).

In implementation 2, the coefficient lines CLin_0, CLin_1 ...... are not common. By virtue of connectivity of different input lines to all the coefficient elements [c(0), c(1).....], the realization of coefficient block [A] using share-able elements is not present. Another feature of this structure is that it inherently requires lesser storage space, represented as [$Z^{-1}$], unlike in previous implementation, here the storage is done before multiplication. For input frame of m bit and coefficient of size n bit, the storage area of each delay element [$Z^{-1}$] is m. The total storage space is m* (number of coefficients -1).

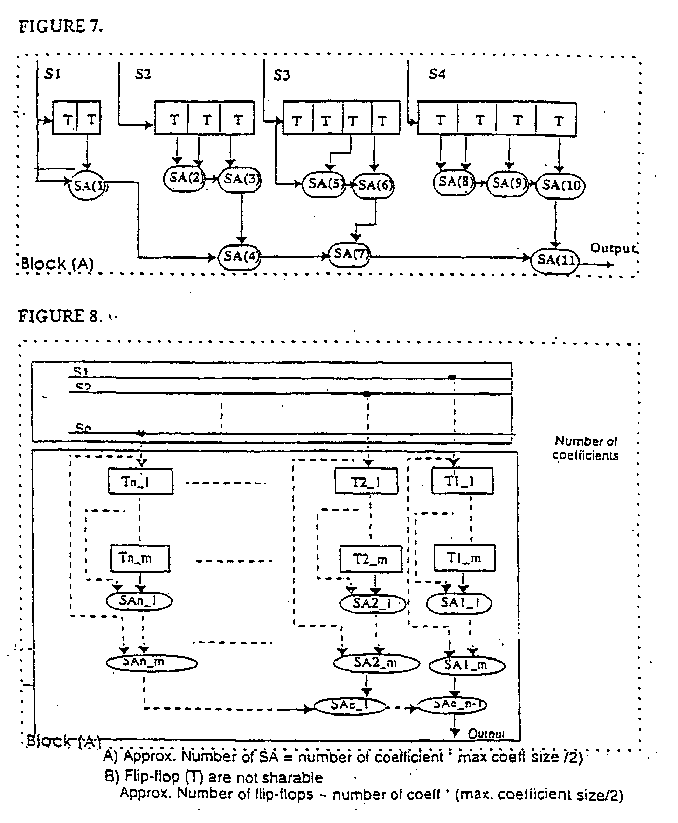

The invention is proposed in reducing the area of the coefficient block [A] and have share-able elements in coefficients, even if the coefficient lines CLin_0, CLin_1,.....are not commonly connected. For existing configuration as shown in "Figure 7" and "Figure 8" , the share-ability of hardware in coefficient block [A] is a limitation.

Also, as described in previous -section, implementation 2 is area efficient with respect to implementation due to reduced delay elements size. Over and above this by having share-able multiplier or reduced coefficient block [A], which are the key features of the invention, implementation 2 becomes still more area-efficient. This reduction is extendable to other filter based on coefficient block [A], as stated in the first section. The present invention operates on integer valued coefficient.

Further, to quote Norsworthy and Crochiere (Delta-Sigma Data Converters IEEE press pp-435, copyright 1997):

"Bit-serial architecture reduce the interprocessor communication down to 1 bit. Generally the number of processors is very large, but because each processor is so small, the overall economy is very high. Bit serial architectures are usually most effective for filters having a few state variables, such as IIR filters and the wave-digital filters. For this reason, bit- serial techniques are less frequently applied to FIR. structures, especially when the filter length is relatively long......."

However, the present invention applies optimization techniques for reducing the area in large sized coefficients by applying a number of optimizations in FIR/IIR filter structures.

To elaborate the applicant's optimization techniques, consider a FIR filter with coefficient as 5, 14, 25, 30, 25, 14, and 5. Though the size of the coefficients in this example is small, it is enough to elaborate the minimization proposals. In most of the practical cases, the coefficients are symmetrical.

Stating the FIR filter equation in time and frequency domain

$$Y(n) = c(0) X(n) + c(1) X(n-1) + c(2) X(n-2) +.....c(n) X(0)$$

$$Y(z) = X(z) [c(0) + c(1) Z^{-1} + c(2) Z^{-2} + c(3) Z^{-3} + c(4) Z^{-4} + c(5) Z^{-5} + c(6)$$

$$Z^{-6}+.................+c(n) Z-n]$$

where X, Y are the input & output respectively and c(0), c(1).....c(n) represent the coefficients value.

Using the coefficient values in above equation

$$Y(n) = 5 X(n) + 14 X(n-1) + 25 X(n-2) + 30 X(n-3) + 25 X(n-4) +14 X(n-5) + 5$$

$$X(n-6)$$

$$Y(z) = X(z) [5 + 14 Z^{-1} + 25 Z^{-2} + 30 Z^{-3} + 25 Z^{-4} + 14 Z^{-5} + 5 Z^{-6}] \qquad \text{(EQ 1)}$$

**The Existing Method and Minimization**

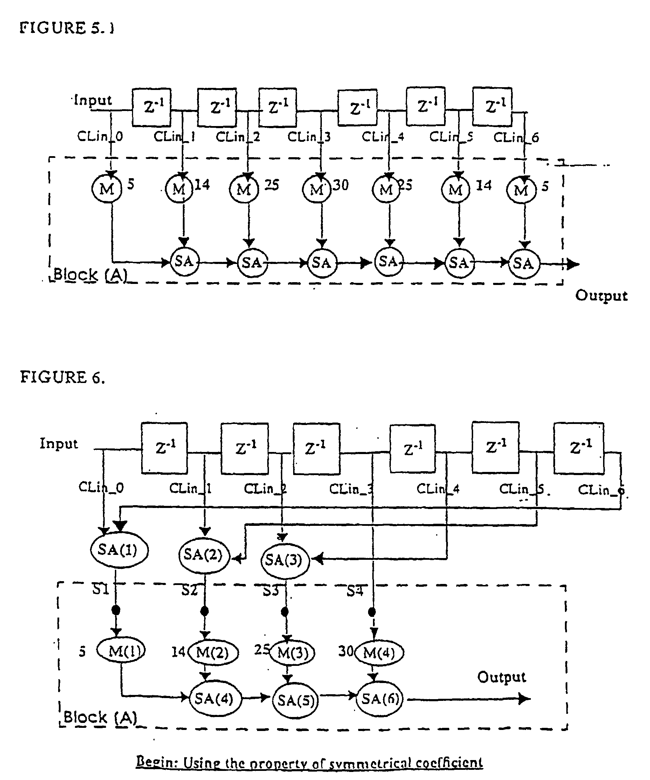

"Figure 5" of the drawings shows FIR filter structure of implementation 2. The figure illustrates the realization of FIR filter represented by "Equation 1".

In one of the known optimization technique, is taken advantage of the symmetry in the coefficients. The streams which have to be multiplied with the same coefficients can be added first and then multiplied. For a large filter structure, this leads to a reduction by 45% in the coefficient block [A]. (see "Figure 6" of the accompanying drawings)

This is done by restructuring the equation as under:

$$Y(z) = X(z)[5*(1+Z^{-6}) + 14*(Z^{-1}+Z^{-5}) + 25*(Z^{-2}+Z^{-4}) + 30* Z^{-3}] \qquad \text{(EQ 2)}$$

For the rest of the optimization proposals it will be talking about only the multiplier adder series which is shown in the dotted box referred to as coefficient block [A]. "Figure 7" of the drawings shows the traditional way of implementation of the example structure for coefficient block [A], wherein S1 to S4 represent the input lines connected to delay block [$Z^{-1}$] through coefficient lines CLin_0 to CLin_6 depicted in "Figure 6" of the drawings. The input lines S1 to S4 are separately connected to a unit delay element [T] for performing a multiplication by a factor of 2 and a serial adder is used to perform serial addition of data. This represents the multiplier less realization of filter coefficient block [A] where the property of flip-flop (unit delay element [T]) as multiplier of factor of two is used.

Mathematically, the restructured equation according to the structure is stated as

$$Y(nT)=(4+1) S1+ (8+4+2)S2 + (16+8+1)S3 + (16+8+4+2)S4 \qquad \text{(EQ 3)}$$

In this implementation, input lines S1, S2, S3, S4 are not commonly connected. Hence this-restricts to achieve a share-able hardware in coefficient block [A]. Thus all the function/operations of this block represent unique hardware. The elements required by the terms are listed as

> First term = two unit delay elements and one serial adder,
> Second term = three unit delay elements and two serial adders,
> Third term = four unit delay elements and two serial adders, and
> Fourth term = four unit delay elements and three serial adders.

Final addition of all the four term would require three serial adders.

The generalized structure of "The Existing Method and Minimization" is depicted in "Figure 8". In the structure, each column represents a coefficient value. The unit delay elements, shown as T1_l to T1_m in column1, defines connectivity with input line S1. In similar fashion, unit delay elements, shown as Tn_l to Tn_m in column n, defines the connectivity with input line Sn.

The presence of one of the elements in columns 1 to n (i.e T1_l to T1_m, T2_l to T2_m......Tn_l to Tn_m) is determined by coefficient value. Thus depending on coefficient value on lines S1 to Sn, the number of unit delay elements [T] in a column is determined. Also the number of serial adders/subtractors[SA/ SS] in columns is represented as (SA1_l to SA1_m,SA2_l to SA2_m......SAn_l to SAn_m). The presence of one of these elements is again defined by the coefficient value.

In the structure, the unit delay elements [T] are arranged in shift register form. The input to first unit delay element is connected to one of the input liner S. While the input to a serial adder or subtractors is connected from input lines S1 to Sn and/or one of the output of input delay elements of shift register, depending on the coefficient value. Finally, using serial adders SAe_1 to SAe_n-1 the addition/subtraction of serial adders/subtractors of all the coefficient terms depicted in columns is done. The final output is the output of last addition/subtraction.

Among the input lines S1 to Sn, the unit delay elements are not share-able and also the serial adders in each column are also not share-able. Tnus limited minimization is possible in this structure.

**Minimization**

This structure reduces the hardware of the coefficient block [A] by having share-able elements in coefficients, even if the coefficient lines CLin_0, CLin_1,.....are not commonly connected. This structure reduces the area by approximately 30-50%. of "Figure 7" of the drawings by reducing the number of components and by having share-ability of components. Here the optimization techniques are illustrated with examples and end of this section depicts the generalized equation and structure of the device.

Continuing the same example of FIR filter and using "Equation 3" of previous section.

$$y(nT)= 5 * S1 + 14 * S2 + 25 * S3 + 30 * S4$$

$$Y(nT)=(4+1)S + (8+4+2)S2 + (16+8+1)S3 + (16+8+4+2)S4$$

The applicants proceed to share the shift registers (multiply by 2) of the design.

$$=(S3+S4)*16+(S2+S3+S4)*8+(S1+S2+S4)*4+(S2+S4)*2+(S1+S3)$$

$$=(S1+S3)+2*(S2+S4+2*(S1+S2+S4+2*(S2+S3+S4+2*(S3+S4)))) \qquad \text{(EQ 4)}$$

Finding out the common additive factors

$$A1 = S2+S4$$

$$A2 = S3+S4$$

The "Equation 4" can be further reduced as

$$y(nT) = (S1+S3)+2*(A1+2*(S1+A1+2*(S2+A2+2*A2))) \qquad \text{(EQ 5)}$$

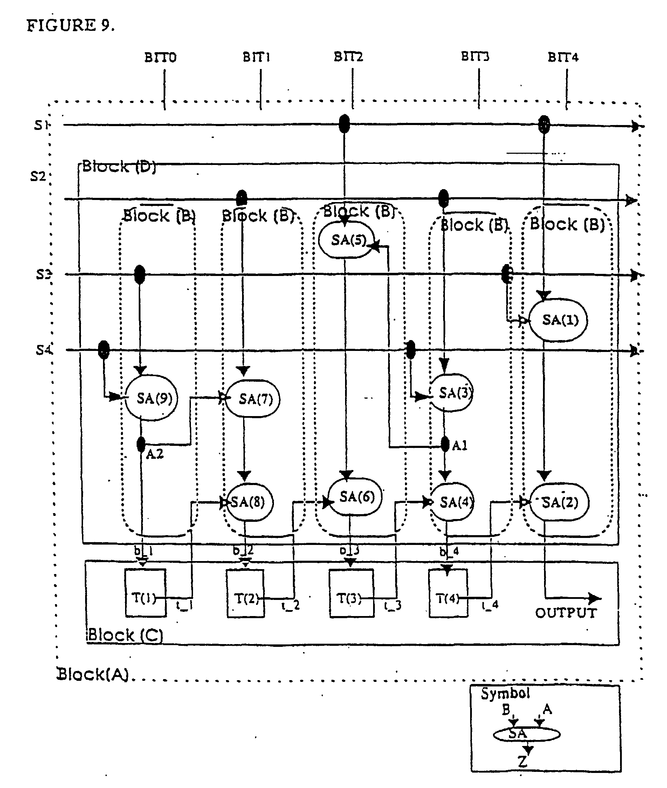

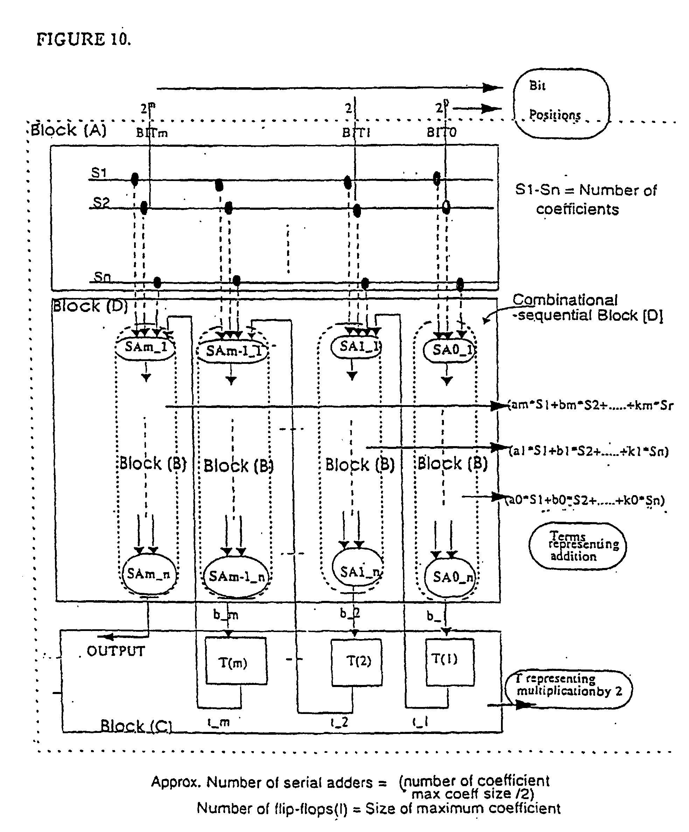

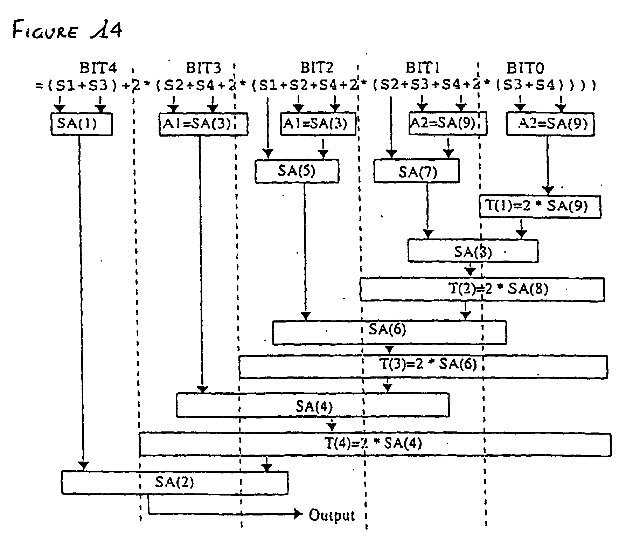

The implementation flow for this equation is illustrated in Figure 14 the hardware implementation is shown in "Figure 9" and "Figure 10" of the drawings [e.g SA(1), SA(2) etc. are used for representing adders, T(1), T(2) etc. are used for representing the unit delay]. In the flow of implementation, S1, S2, S3, S4 represents four input lines. The primary addition is done using serial adders SA(1), SA(3), SA(9) representing addition of terms S1+S3, S2+S4, S3+S4. While the secondary and tertiary addition is done using the adders SA(5), SA(7), SA(8), SA(6), SA(4), SA(2). The multiplication by factor of two is done using the unit delay elements T(1), T(2), T(3), T(4).

Implementation of hardware is shown in "Figure 9" of the drawings, wherein the input lines S1 to S4 represent the lines connected to delay block [Z$^{-1}$] through coefficient lines Clin_0 to CLin_6 depicted in "Figure 6" of the drawings. The input Lines S1 to S4 are connected to a combination logic blocK [B] for performing the serial addition/subtraction, for which serial adders/subtractors are used within combination logic block [B]. The output of each combination logic block [B] is terminated with a unit delay element [T], which represents the combination logic block output being multiplied by a "factor of 2". The output b_1 of combination logic block [B] which is at bit position 0 is fed to the input of the unit delay element T(1), in turn the output line t_1 of the unit delay element [T(1)] is fed to next combination logic block [B]. Thus all addition defines a bit position before getting multiplied by 2 and changing to next bit position. All unit delay elements [T] are represented by unit delay cluster [C]. In the structure, the unit delay element [T] representing multiplication by a "factor of 2", is pushed to share between various coefficient values, hence reducing the number unit delay elements [T] (Flip-Flop).

In the minimization of "Figure 9" of the drawings, approximate area calculations is 9 serial adders+ 4 unit delay elements = 22 Units, whereas the area calculation of "Figure 7" of the drawings is 11 serial adders$^+$ 13 unit delay elements = 35 units, (assuming 1 Unit = 1 full adder = 2 helf adder = 1 unit delay element & serial adder = 2 Units). This resulted in 37% saving in area (13/35 * 100).

A different existing implementation of a filter is disclosed in WO 94 23493 A, which relates to a method and an arrangement in a transposed digital FIR filter for multiplying a binary input signal by tap coefficients, and to a method for designing such a filter. The invention comprises a shift register shifting in the direction of the least significant bit and copying the most significant bit or filling in zero values. The register receives the binary input signal of the filter and has outputs for outputting the content of the desired bit positions. A plurality of bit-serial subtractor and adder elements multiply the binary input signal by N+1 different tap coefficients by combining output bits of the shift register. The subtractor and/or adder elements form a network wherein at least one element participates in the multiplying operation of at least two different tap coefficients.

## DETAILED DESCRIPTION OF THE INVENTION

### Minimization Proposed in the present invention

The invention reduces the area of the coefficient block [A] by having share- able elements in coefficients, even in the implementation where the coefficient lines CLin_0, CLin_1,.....are not commonly connected (shown as architecture [A]). This coefficient block [A] when applied in implementation2 ("Figure 4") of FIR filter, makes it still more area-efficient. This reduction is extendable to other filter based on coefficient block [A], as stated in the first section.

An area efficient implementation of filter coefficient block is done using full adders (FA) instead of serial adder (SA). It is known that a serial adder consists of one full adder (FA) and one flip-flop (T). (refer "Figure 3" of the drawings). This makes serial adder(SA) twice expensive in area as compared to one full adder(FA) [area of serial adder (SA) = 1 FA+1T = 2 units while the area of 1FA = 1 unit]. In this implementation the reduction in area of the coefficient block [A] is achieved by maximising the use of full adder (FA) i.e by replacing serial adders (SA) with full adders (FA) in the coefficient block [A].

The above is achieved by providing a digital logic architecture, a digital filter and a combination logic structure as claimed, in claims 1, 5 and 6, respectively.

In the present invention, preferably, the area minimal realization of digital filters based on coefficient block [A] is achieved when it is operated in bit serial fashion.. The structure provides hardware minimization for finite impulse response(FIR) filter, infinite impulse response filter(IIR) and for other filters and applications related to combinational logic consisting of delay elements (T), multipliers (M), adders and subtractors. Further optimization technique in combination logic cluster [D] is done by using common adders (FA) and common subtractors (FS) and using this shared outputs or by using subtractors (FS) instead of adders, when the coefficient value is closer to power of two or by minimizing the use of subtractors by taking common subtraction operators and using adders instead.

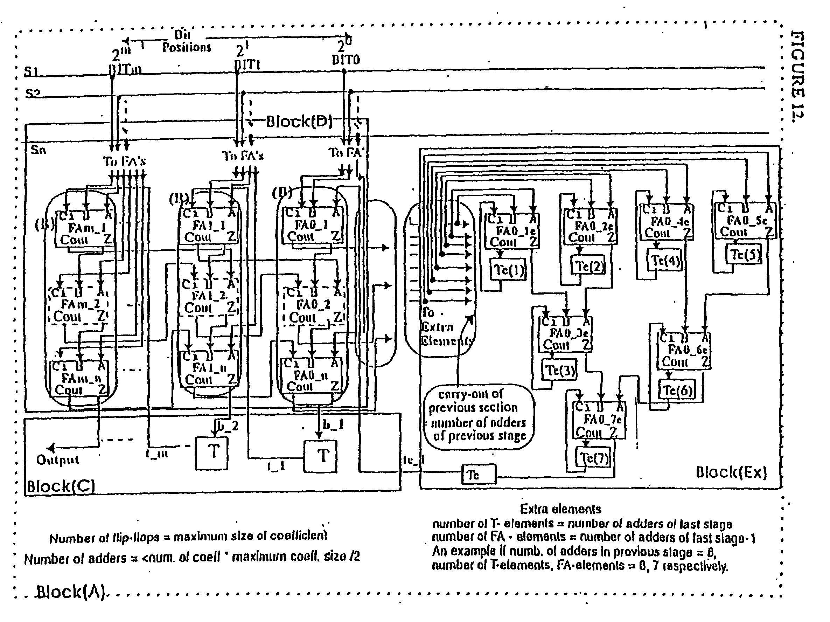

The present invention, when used in implementation 2 of FIR/IIR filter and similar structure of filters, results in quite area efficient realization of the filter, the storage area in implementation 2, referred as delay elements [$Z^{-1}$], is smaller as compared to implementation 1 which is present due to inherent property of the structure of implementation 2, and an additional saving in area in filter coefficient realization design is achieved by using the claimed structure of coefficient block [A] of "Figure 12".

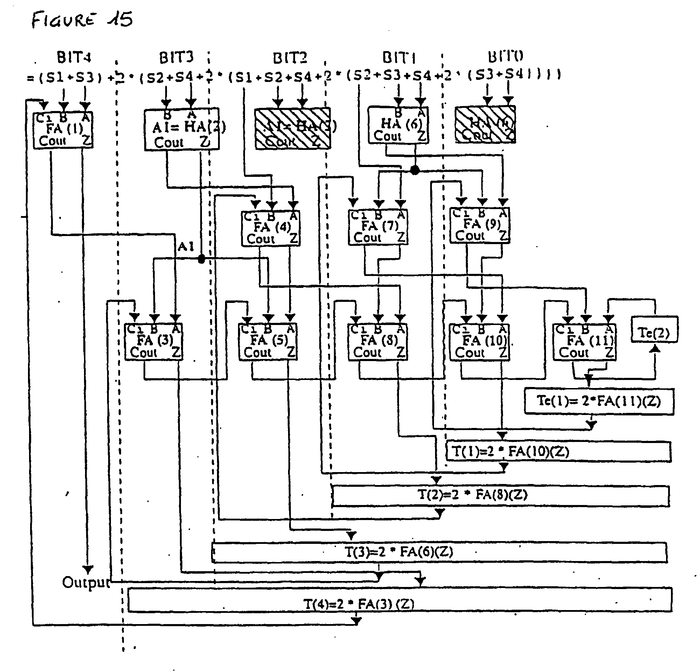

In the implementation flow explained under with reference to Figure 15, the carry-out (COUT) pin of full adder (FA) of each stage is fed to carry-in (CIN) input of full adder (FA) of previous stage i.e stage preceding the flip-flop (T) element. In this way, Flip- Flop (T1, T2, T3, T4) which is used for multiplication by two, is used again, to function as carry storage and to enable full adder to perform as one bit serial adder.

Rewriting the equation of FIR filter for the example shown in previous section

$$y(nT) = (S1+S3)+2*(A1+2*(S1+A1+2*(S2+A2+2*A2))) \tag{EQ 6}$$

Using full adder (FA) component in "Equation 6" , it is seen that the number of full adders used are the same as the number of one-bit serial adders used in the earlier architecture. In the present invention, depending carryout BIT0 position, some half adders or some extra elements are present.

As shown in implementation flow of Figure 15, the equation defines the bit position as BIT0 to BIT4, which is the position of "multiplication by power of two". (e.g BIT0 represents multiplication by 20). At BIT0 position addition of S3+S4 is performed and the output is terminated at T(1). The output of T(1) defines the next bit position BIT1, which performs addition of S2+S3+S4 using the full adder and also the output of flip-flop T(1). The output of this addition is again terminated at Flip-Flop T(2). The structure is repeated in next BIT positions. The carryouts of full adders are fed to the previous bit position. The final addition of BIT position BIT4 gives the output of the coefficient block [A].

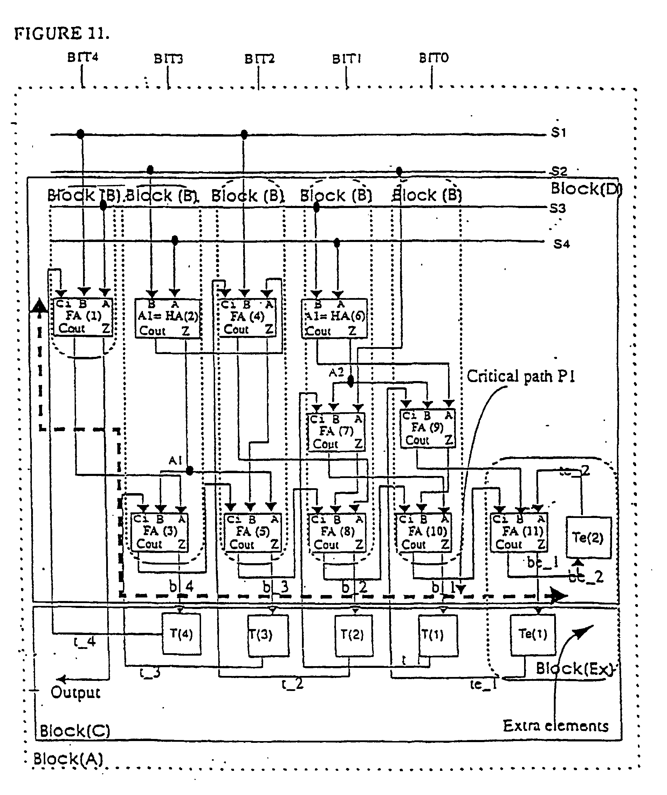

The implemented structure is shown in "Figure 11", wherein the input lines S1 to S4 represent lines connected to delay block [$Z^{-1}$] through coefficient lines Clin_0 to CLin_ 6 depicted in "Figure 6" of the drawings. The input Lines S1 to S4 are connected to combination logic block [B] for performing the serial addition/subtraction for which full adders and full subtractors are used within combination logic block [B]. All unit delay elements [T] are represented by unit delay cluster [C].

The adders at all the bit positions, represented by FA(1), HA(2),.....FA(10) are clustered in combination logic cluster [D]. The adder inputs are connected from coefficient lines S1, S2, S3, S4 and from unit delay element of previous bit position. The addition/subtraction is performed in combination logic block [B] and the final output of last adder is connected to a unit delay element, which is used for "multiplication by factor of 2". The interconnection from combination logic block [B] to unit delay element [T], is represented as b_1, b_2, b_3, b_4. The outputs of unit delay elements [A] are connected to one of the inputs of combinational logic block [B] of next bit position (i.e connected to input of first full adder of combination logic block [B], and these interconnections are represented as t_1. t_2, t_3, t_4, and Bit positions are marked as BIT0, BIT1, BIT2, BIT3, BIT4. An example illustration of connectivity is explained here. The output b_1 of combination logic block [B] which is at bit position BIT0 is fed to the input of unit delay element T(1), in turn the output line t_1 of unit delay element [T(1)] is fed to next combination logic block [B]. Thus all addition defines a bit position before getting "multiplied by factor of 2" and changing to next bit position.

The connection of pin COUT (carryout) of all the full adder of one stage is explained here.

The connection of carry-out (COUT) pin of full adder (FA) of each combination logic block [B] is fed to one of the inputs of full adder (FA) of previous combination logic block [B] i.e, the block preceding the unit delay element [T] of unit delay cluster [C]. Thus utilizing the unit delay element [T] of that bit position again. This enable using the unit delay element [T] for carry storage, by all full adders in that bit position, during serial addition operation.

In the invention, the unit delay element [T] is used for dual purpose

1) Multiplication of output of combination logic block [B] by factor of two, used by all coefficients.

2) Utilizing the same unit delay elements [T] commonly by combination logic block [B] for using with a full adder to enable it to perform as a serial adder (SA).

For example, at bit position 3, the half adder HA (2) performs addition data on S2, S4 lines The output Z, represents shared adder A1, being fed to full adders FA (3) and FA(5). The output Z of FA(3) defines bit position 3 is terminated at unit delay element [T(4)]. The carry-out pin (Cout) at this bit position is connected to carry-in pin (Cin) of any full adder [FA(5)] in previous bit location, hence utilizing the unit delay element [T(4)] to enable all the full adders at this location to work as a serial adder. The structure of a serial adder is essentially a full adder along with a unit delay element [T] connecting the carry-out pin (Cout) of full adder to it's carry-in pin (Cin).

In this implementation, there are some extra elements such as full adder FA(11) and unit delay elements Te (2), Te(1) which are required to terminate the carry out(Cout) at the bit position 0. The number of full adders is equal to the number of Cout lines-1 in Bit position 0 and the number of unit delay elements [T] is equal to the number of Cout lines in Bit position 0. The extra elements are represented as extra logic block [Ex].

The circuit is structured into unit delay cluster [C] consisting of unit delay elements [T] and combination logic cluster [D] consisting of fuel adders and substractors.

a) unit delay cluster [C] having sequential elements is common for all the coefficients and have share-able unit delay elements [T] positioned at end position of each combination logic block [B].
b) combination logic cluster [D] having combination logic blocks [B] which are essentially full adders and subtractors. Not only the hardware within combination logic blocks [B] are share-able but also across various combination logic blocks. Hence the components hardware within combination logic cluster [D] is minimized.

The minimization in combination logic cluster [D] is achieved by using following minimization techniques

1) Sharing of common adder term, i.e. utilizing the common adder multiple times.
2) Using subtraction instead of addition when the coefficient is close to power of 2e.g 63 is better realized as (64-1) than (32+16+8+4+2+1). In former case the number of subtractors is 1 as compared to 5 adders in latter case.
3) Taking common subtraction operation and maximizing the use of adder are applied. This is because subtraction is expensive as compared to addition operation.

In present minimization of "Figure 11", approximate area calculations is done as 9 FA + 2 HA + 6 T = 16 Units. As the applicants have seen that the area in minimization under section "The Existing Method and Minimization" and "Figure 7" is 35 units. Area in minimization under section "Minimization" ("Figure 9") is 22 units. Current minimization is an improvement of 54% {(35-16)/35} & 27% {(22-16)/22} of coefficient block respectively over the two structures. (assuming 1 Unit = 1 FA = 2HA = 1T & serial adder = 2 Units)

GENERALIZED STRUCTURE OF THE INVENTION

The invention provides an area efficient realization of filter coefficient block[A] applicable to filters devices such as FIR, IIR and other filter structures based on this block. This architecture is also applicable to combinational and sequential logic consisting of adders, subtractors, multipliers and flip flop [T]. This architecture is realized using the elements full adders (FA), full subtractors (FS) and flip-flop[T].

Beginning with the generalized equation of FIR filter coefficient block(A)

$$y(nT) = a * S1 + b * S2 + c * S3 + \ldots\ldots\ldots\ldots k * Sn \tag{1}$$

where a, b,....k represents filter coefficients. S1, S2..... represents input lines corresponding to the coefficients.

Now, representing each coefficient as addition of terms arranged in power of two and applying it to the equation.

$$y(nT) = (2^m{*}am + \ldots\ldots 2^1{*}a1 + 2^0{*}a0) * S1 + (2^m{*}bm + \ldots\ldots 2^1{*}b1 + 2^0{*}b0) * S2 +$$

$$(2^m{*}cm + \ldots\ldots\ldots 2^1{*}c1 + 2^0{*}c0) * S3 + \ldots\ldots + (2^m{*}km + \ldots\ldots 2^1{*}k1 + 2^0{*}k0) * Sn$$

Further taking "2" as common factor we get the generalized equation for architecture under claim as.

$$Y(nT) = (a_0*S_1 + b_0*S_2 + .... + k_0*S_n)$$

$$+ 2^1 ((a_1*S_1 + b_1*S_2 + .... + k_1*S_n) +$$

$$2^1 ((a_2*S_1 + b_2*S_2 + ... + k_2*S_n) +$$

$$2^1 ((a_3*S_1 + b_3*S_2 + ... + k_3*S_n) + ......... +$$

$$2^1 ((a_m*S_1 + b_m*S_2 + ...... + k_m*S_n)))))$$

where $a_0, a_1, ..... a_m$ and $b_0, b_1, ... b_m$ and $k_0, k_1, ....... k_m$ represents the sign of coefficients [i.e they have value (+ / -) 1 or 0]. The architecture realization in "Figure 12" is done using the sequential elements like unit delays [T] and combinational elements such as full adders (FA) and full substractors (FS).

In "Figure 12", the input data is present on input lines S1, S2,.....Sn. [where n represents the number of coefficients of the filter] The addition terms of the equation.[(a0*S1+b0*S2+....+k0*Sn),(a1*S1+b1*S2+.....+k1*Sn)........ (am*S1+b m*S2+.......+km*Sn)] are represented as combination logic blocks [B]. Block [B] is a combinational block consisting of full adders (FA) and full subtractors (FS). The values a0, b0,..... etc. represent value (+ / -)1 or 0. The connection of full adders and subtractors to input lines S1, S2....Sn and interconnection of the full adders and subtractors depend on the value of coefficients. This is because the value of coefficient determines the value of a0, a1,.....etc. and hence it defines the interconnections between them.

All the addition/subtraction operations at a bit location is performed in a combination logic block [B] and the output of each combination logic block [B] is terminated at unit delay elements [T], which are essentially used to multiply the combination logic, ouput by "a factor of two" and passing the output to next bit position. The unit delay elements T[1], T[2],......T[m] are used for this. The connection lines b_1, b_2,....b_m are used for termination of output of combination logic block [B]. The bit positions of serial data frame are marked as BIT0, BIT1,.....BITm. The number of unit delay elements [T], depends on the size of maximum coefficient and is share-able for all the coefficient in the coefficient block [A]. Also all the combination logic blocks [B] are clustered together as a combination logic cluster [D] and all the unit delay elements T[1], T[2]......T[m] are clustered together in a unit delay cluster [C]. Thus separating the sequential and combinational logic. The input of the unit delay element [T] is final output of combination logic block [B] and the output of unit delay element [T] is connected to the one of the inputs of combination logic block [B] of next bit position (i.e connected to input of first of full adder or subtractor of combination logic block [B] depending upon the sign value+/-). The interconnections from unit delay cluster [C] to combination logic block [B] is represented as t_1, t_2,.....t_m.

Thus, the unit delay elements [T] clustered as a unit delay cluster [C] is share-able for all the coefficients and the full adders subtractors are clustered as a combination logic block. The carry- out pin of full adder (FA) of each combination logic block [B] is fed to input of full adder (FA) of previous combination logic block [B] i.e block preceding the unit delay element [T] of unit delay cluster [C]. In this way, we will share the same unit delay element [T] which is used for multiplication by factor of two (T1, T2, T3... Tn) to the implementation of the carry structure in the one bit serial adder.

Extra components represented as a extra logic block [Ex] are used for connecting the carry-out of all the adders/subtractors (FA/FS) of last combination logic block of combination logic cluster [D] i.e bit position BIT0. Full adders/full subtractor[FA/FS] and unit delay elements [T] are used in this block. The line COUT (carryout) of bit position BIT0 is connected to extra logic block [Ex] (typically to inputs of element such as full adders or full subtractor. Now using a unit delay [T], element the carryout (COUT) of each full adder or subtractor is fed to the carry-in pin of the same lement. Also, for connection of a full adder output to the input A or B of next full adder. A binary tree can be formed here. The number full adders of unit delay elements in extra logic block [Ex] are equal to the number of carryout pins -1 and to the number of carryout pin, respectively.

In the invention, optimizations in hardware in both clusters [C] and [D] is achieved with the reduced unit delay elements [T] and the adder/subtractor area (FA,FS). The gain in hardware is explained below.

## Hardware reduction in block [C]

For filter having large size coefficient, this structure reduces the area of coefficient block [A] by 50-75% of the area of coefficient block [A].

Before beginning to prove the statement, the calculation of elements is formularize for

    1) number of unit delay elements [T] (Flip-Flops),
    2) number of serial adders (SA) or full adders (FA).

This comparison is done here. The generalized structure of "The Existing Method and Minimization" is illustrated in "Figure 8". The other structure for comparison are "Minimization in "Figure 10" and "Generalized structure of the invention" in "Figure 12" of the drawings.

1) The number of unit delay elements, [T] in the coefficient block [A] depends on the size of all the coefficients. The approximate and pessimistic formula for calculation of total unit delay elements (T) in coefficient block [A], in "The Existing Method and Minimization" is equal to the average size of coefficient multiplied by the number of coefficients ("Figure 8"), where average size of coefficient is calculated pessimistically as Maximum coefficient size / 2. While in the "Minimization and "Proposed Minimization", the number of unit delay elements [T] are equal to the maximum size of coefficient, since the unit delay elements [T] are share-able here].

2) The approximate formula for calculation of total serial adders (SA) in coefficient block [A] for the mentioned above cases is equal to the adders per coefficient multiplied by the number of coefficients. Adders per coefficient block solely depend on value of coefficient. Assuming no optimization in worst case, number of adders per coefficient is equal to the number of coefficient multiplied by the maximum coefficient size and divided by 2.

Now using the mentioned formula on an example filter having 20 coefficient. The coefficient having maximum value is in 16 bits (e.g. maximum coefficient value is +32767 or -32768 in 2's complement representation). In the present example, average size of the coefficient approximated by the formula is 8 bit. For "The Existing Method and Minimization", total number of flip-flops(T) required for implementation is 8 * 20 = 160. In contrast to this, "Minimization" and "Proposed Minimization" would require only 16 Flip-Flops. The number of flip-flops of all the coefficients are shareable and are limited to the coefficient which has the maximum value. Using the formula for adder's calculation, the number of adders for three cases are 8 * 20 = 160 (approx.).

Area calculation for "The Existing Method and Minimization" is 160 T +160 SA = 480 units. Area calculation for "Minimization" is 16 T +160 SA = 336. Area calculation for "Proposed Minimization" is 16 T +160 FA +(extra elements 8T+7 FA)=191. Assuming that average number of full adder per bit position is 8. We will generalize the calculation of number of extra elements here. These extra elements are needed to terminate the carry-out of last (LSB) position. Thus if the average number of full adders is 8, the extra elements 7 full adders and 8 unit delay elements (7, 8T) are needed to terminate the carry-outs' of LSB position. This is shown in "Figure 12". Thus we see that the present invention has an area improvement of approximately by 60% {(480-190)/480} of coefficient block over "The Existing Method and Minimization".

**Hardware reduction in block [D]**

For hardware reduction in combination logic cluster [D], following minimization are applied.

1) sharing of common adder term and using it in combination logic cluster [D]
2) using subtraction instead of addition when the coefficient is close to power of 2 e.g 63 is better realized as (64-1) than (32+16+8+4+2+1)
3) Taking common subtraction operation and maximizing the use of adders

For approximate area calculation following assumption is made (1 Unit of Area = 1 FA = 2HA = 1T & SA=SS= 2 Units of Area).

**Advantages involved in the present invention**

The Area gets reduced by 50-75% (of the coefficient block[A]) for big filter structures, if all the 3 optimization steps, as discussed in previous section "Hardware reduction in combination logic cluster [D]", are applied.

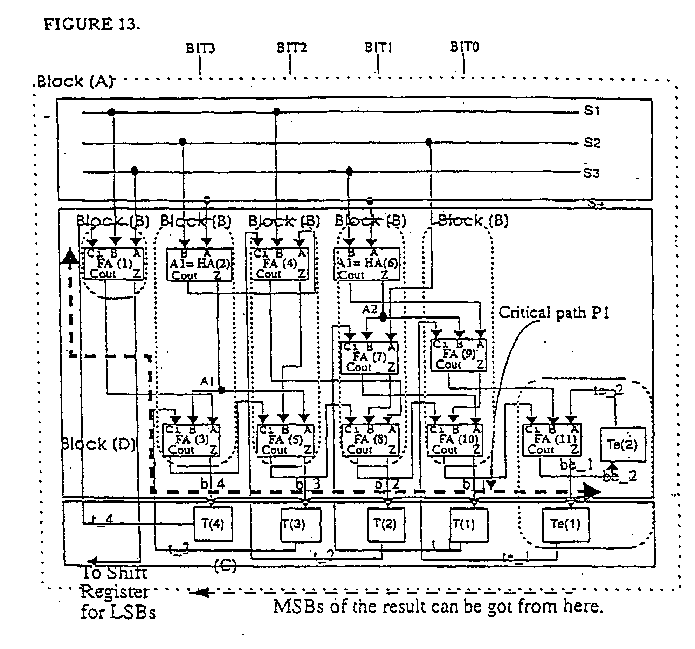

The last proposed architecture ("Figure 12") is a proper Mealy type machine. Many a times, the output has to be converted back to parallel data format. In that case, the outputs from the same shift registers can be used ("Figure 13").

One bit-serial multipliers could be still multiplexed for the proposed architecture if the specifications permit (i. e. if the frequency of operation is not very high.)

**Claims**

**1.** A digital logic architecture for realization of coefficients for a digital filter or a combination/sequential logic structure performing operations such as additions and/or subtractions and/or multiplications and/or delays, said digital logic architecture comprising:

- *n* serial coefficient input lines (S1, S2, ..., Sn), where n is the number of coefficients to be realized; and
- a coefficient block (A) receiving inputs from the *n* coefficient input lines (S1, S2, ..., Sn) and providing an output;

    said coefficient block (A) comprising:

- a combination logic cluster (D) having *m+1* combination logic blocks (B0, B1, ..., Bm), where *m* is an integer determined as the value of log$_2$ of the maximum coefficient value rounded up to the next integer value, said combination logic blocks receiving inputs from the coefficient input lines (S1, S2, ..., Sn), and performing addition and/or subtraction of the inputs from the coefficient input lines (S1, S2, ..., Sn) to respectively generate output terms a0·S1+b0·S2+...+k0·Sn, a1·S1+b1·S2, ..., k1·Sn, ..., am·S1+bm·S2+...+km·Sn, wherein each of a0, b0, ..., k0; a1, b1, ..., k1; ...; am, bm, ..., km has the value *1, -1 or 0, and S1, S2, ..., Sn are the inputs from the coefficient input lines; and
- a unit delay cluster (C) having *m* unit delay elements (T(1), T(2), ..., T(m)), the *i*-th unit delay element, with *i* = 1...*m*, receiving as input the output term from the (*i*-1)-th combination logic block (B0, B1, ..., Bm), multiplying the received input by a factor of two, and outputting the resultant product to an input of the *i*-th combination logic block (B1, B2, ..., Bm);

    wherein said combination logic blocks (B0, B1, ..., Bm) each have one or more adders (SA) or subtractors (SS), the carry-out (Cout) of each adder (SA) or subtractor (SS) of said *i*-th combination logic block (B0, B1, ..., Bm) being fed to an input of an adder (SA) or subtractor (SS) of said (*i*-1)-th combination logic block (B0, B1, ..., Bm), such that the same delay unit block (T) is used for multiplication by a factor of two and also for the carry structure in a bit serial adder function.

2. A digital logic architecture as claim in claim 1, wherein said combination logic blocks (B0, B1, ..., Bm) are arranged as a matrix of *(m+1)* x *n* order.

3. A digital logic architecture as claimed in claim 1 or 2, wherein one or more interconnections are provided between one of the adders and/or subtractors of the combination logic blocks (B0, B1, ..., Bm) for sharing the adders and/or subtractors according to said one or more interconnections respectively and thus minimising the number of adders and/or subtractors required for implementation of the digital filter or the combination/sequential logic structure and consequently minimising an area of said digital logic architecture on which said combination logic blocks (B0, B1, ..., Bm) are disposed.

4. ,A digital logic architecture as claim in any one of claims 1 to 3, wherein when one of the coefficients to be realised is close to, but less than, a power of two, one or more serial subtractors are used to generate said coefficient.

5. A digital filter comprising a digital logic architecture realising filter coefficients, wherein said digital logic architecture is a digital logic architecture as claimed in any one of the foregoing claims 1 to 4.

6. A combination/sequential logic structure for performing operations such as additions and/or subtractions and/or multiplications and/or delays, said combination/sequential logic structure comprising a digital logic architecture realising coefficients for performing said operations, wherein said digital logic architecture is a digital logic architecture as claimed in any one of the foregoing claims 1 to 4.

**Patentansprüche**

1. Eine Digitallogikarchitektur zur Realisierung von Koeffizienten eines Digitalfilters oder eine Kombinations/Sequentiallogikstruktur zur Ausführung von Operationen wie beispielsweise Additionen und/oder Subtraktionen und/oder Multiplikationen und/oder Verzögerungen, wobei die Digitallogikarchitektur Folgendes aufweist:

- *n* serielle Koeffizienteneingangsleitungen (S1, S2, ..., Sn), wobei n die Anzahl der zu realisierenden Koeffizienten ist; und
- einen Koeffizientenblock (A), der Eingangsgrößen von den *n* Koeffizienteneingangsleitungen (S1, S2, ..., Sn) empfängt und eine Ausgangsgröße vorsieht;

wobei der Koeffizientenblock (A) Folgendes aufweist:

- einen Kombinationslogikcluster bzw. eine -zusammenballung (D) mit *m+1* Kombinationslogikblöcken (B0, B1, ..., Bm), wobei *m* eine ganze Zahl ist bestimmt als der Wert von $\log_2$ des maximalen Koeffizientenwertes aufgerundet auf den nächsten ganzen Wert, wobei die Kombinationslogikblöcke Eingangsgrößen von den Koeffizienteneingangsleitungen (S1, S2, ..., Sn) empfangen und die Addition und/oder Subtraktion der Eingangsgrößen von den Koeffizienteneingangsteitungen (S1, S2, ..., Sn) ausführen, um jeweils Ausgabeausdrücke a0·S1+b0·S2+ ... + k0·Sn, a1·S1+b1·S2,..., k1·Sn, ..., am·S1+bm·S2+ ... +km·Sn zu erzeugen, wobei jede Größe von a0, b0, ..., k0; a1, b1, ..., k1; ...; am, bm, ..., km den Wert *1, -1 oder 0 hat, und wobei S1, S2, ..., Sn Eingangsgrößen von den Koeffizienteneingangsleitungen sind; und
- ein Einheitsverzögerungscluster oder eine -zusammenballung (C) mit *m* Einheitsverzögerungselementen (T(1), T(2), ..., T(m)), wobei das *i*-te Einheitsverzögerungselement mit *i* = 1 ... *m* als eine Eingangsgröße den Ausgangsausdruck von dem (*i*-1)ten Kombinationslogickblock (B0, B1, ..., Bm) empfängt, wobei die empfangene Eingangsgröße mit dem Faktor von zwei multipliziert wird, und wobei das sich ergebende Produkt an einen Eingang des *i*-ten Kombinationslogikblocks (B1, B2, ..., Bm) ausgegeben wird;

wobei die erwähnten Kombinationslogikblöcke (B0, B1, ..., Bm) jeweils einen oder mehrere Addierer (SA) oder Subtrahierer (SS) aufweisen, wobei der Übertrag (carry-out = Cout) jedes Addieres (SA) oder Subtrahierers (SS) des *i*-ten Kombinationslogikblocks (B0, B1, ..., Bm) in einen Eingang eines Addierers (SA) oder Subtrahierers (SS) des erwähnten (*i*-1)ten Kombinationslogikblocks (B0, B1,.... Bm) derart eingespeist wird, dass der gleiche Verzögerungseinheitsblock (T) für die Multiplikation mit einem Faktor zwei und auch für die Carry- oder Übertragstruktur in einer Bit-Serienaddierfunktion verwendet wird.

2. Eine Digitallogikarchitektur nach Anspruch 1, wobei die erwähnten Kombinationslogikblöcke (B0, B1..... Bm) als eine Matrix der Ordnung *(m+1)* x *n* angeordnet sind.

3. Eine Digitallogikarchitektur nach Anspruch 1 oder 2, wobei eine oder mehrere Zwischenverbindungen zwischen einem der Addierer und/oder Subtrahierer der Kombinationslogikblöcke (B0, B1, ..., Bm) vorgesehen sind, um die Addierer und/oder Subtrahierer zu teilen, und zwar gemäß der erwähnten einen oder mehreren jeweiligen Zwischenverbindungen, und um auf diese Weise die Anzahl der Addierer und/oder Subtrahierer die für die Implementation des Digitalfilters oder der Kombination/Sequentiallogikstruktur erforderlich sind, zu minimieren und infolge dessen eine Fläche der Digitallogikarchitektur zu minimieren, auf der die Kombinationslogikblöcke (B0, B1, ..., Bm) angeordnet sind.

4. Eine Digitallogikarchitektur nach einem der Ansprüche 1 bis 3, wobei dann, wenn einer der zu realisierenden Koeffizienten nahe einem aber weniger als ein Quadrat ist, einer oder mehrere Seriensubtrahierer verwendet werden, um den erwähnten Koeffizienten zu erzeugen.

5. Ein Digitalfilter, welches eine Filterkoeffizienten reagierende Digitallogikarchitektur aufweist, wobei die Digitallogikarchitektur eine Digitallogikarchitektur nach einem der vorhergehenden Ansprüche 1 bis 4 ist.

6. Eine Kombinations/Sequentiallogikstruktur zur Ausführung von Operationen wie beispielsweise Additionen und/oder Subtraktionen und/oder Multiplikationen und/oder Verzögerungen, wobei die Kombinations/Sequentiallogikstruktur eine Digitallogikarchitektur aufweist, welche Koeffizienten realisiert zur Durchführung der Operationen, wobei die erwähnte Digitallogikarchitektur eine Digitallogikarchitektur nach einem der vorhergehenden Ansprüche 1 bis 4 ist.

## Revendications

1. Architecture logique numérique pour la réalisation de coefficients pour un filtre numérique ou une structure logique combinatoire/séquentielle effectuant des opérations telles que des additions et/ou des soustractions et/ou des multiplications et/ou des temporisations, ladite architecture logique numérique comprenant :

- n lignes d'entrée de coefficients en série (S1, S2, ..., Sn), où n est le nombre de coefficients à réaliser ; et
- un bloc de coefficients (A) recevant des entrées en provenance des n lignes d'entrée de coefficients (S1, S2, ..., Sn) et émettant une sortie ;

ledit bloc de coefficients (A) comprenant :

- un groupe de blocs logiques combinatoires (D) ayant m + 1 blocs logiques combinatoires (B0, B1, ..., Bm), où m est un entier déterminé comme la valeur du $\log_2$ de la valeur de coefficient maximale arrondie à la valeur entière supérieure, lesdits blocs logiques combinatoires recevant des entrées en provenance des lignes d'entrée de coefficients (S1, S2, ..., Sn), et effectuant une addition et/ou une soustraction des entrées provenant des lignes d'entrée de coefficients (S1, S2, ..., Sn) pour générer des termes de sorties respectifs a0.S1 + b0.S2 + ... + k0.Sn, a1.S1 + b1.S2, ..., k1.Sn, ..., am.S1 + bm.S2 + ... + km.Sn, où chacun des termes a0, b0, ... , k0; a1, b1, ..., k1; ... ; am, bm, ..., km a la valeur *1, -1 ou 0, et S1, S2, ..., Sn sont les entrées provenant des lignes d'entrée de coefficients ; et
- un groupe d'éléments de retard unité (C) ayant m éléments de retard unité (T(1), T(2), ..., T(m)), le $i^{ème}$ élément de retard unité, où i = 1 à m, recevant en tant qu'entrée le terme de sortie du $(i — 1)^{éme}$ bloc logique combinatoire (B0, B1, ..., Bm), multipliant l'entrée reçue par un facteur 2, et envoyant le produit obtenu en entrée du $i^{ème}$ bloc logique combinatoire (B1, B2, ..., Bm) ;

où lesdits blocs logiques combinatoires (B0, B1, ..., Bm) ont chacun un ou plusieurs additionneurs (SA) ou soustracteurs (SS), la retenue (Cout) de chaque additionneur (SA) ou soustracteur (SS) dudit $i^{ème}$ bloc logique combinatoire (B0 B1, ..., Bm) étant envoyée à une entrée d'un additionneur (SA) ou d'un soustracteur (SS) dudit $(i - 1)^{éme}$ bloc logique combinatoire (B0, B1, ..., Bm), de telle sorte que le même bloc de retard unité (T) soit utilisé pour la multiplication par un facteur 2 ainsi que pour la structure de retenue d'une fonction d'additionneur série binaire.

2. Architecture logique numérique selon la revendication 1, dans laquelle lesdits blocs logiques combinatoires (B0, B1, ..., Bm) sont agencés en une matrice d'ordre (m + 1) $\times$ n.

3. Architecture logique numérique selon la revendication 1 ou 2, dans laquelle une ou plusieurs interconnexions sont prévues entre l'un des additionneurs et/ou soustracteurs des blocs logiques combinatoires (B0, B1, ..., Bm) pour le partage des additionneurs et/ou soustracteurs selon lesdites une ou plusieurs interconnexions respectives, et donc la minimisation du nombre d'additionneurs et/ou soustracteurs nécessaires pour l'implémentation du filtre numérique ou de la structure logique combinatoire/séquentielle, ce qui minimise l'aire de ladite architecture logique numérique sur laquelle sont disposés lesdits blocs logiques combinatoires (B0 B1, ..., Bm).

4. Architecture logique numérique selon l'une quelconque des revendications 1 à 3, dans laquelle, lorsque l'un des coefficients à réaliser est approximativement égal, mais inférieur, à une puissance de deux, un ou plusieurs soustracteurs en série sont utilisés pour générer ledit coefficient.

5. Filtre numérique comprenant une architecture logique numérique réalisant les coefficients du filtre, dans lequel ladite architecture logique numérique est une architecture logique numérique selon l'une quelconque des revendications 1 à 4 précédentes.

6. Structure logique combinatoire/séquentielle pour effectuer des opérations telles que des additions et/ou des soustractions et/ou des multiplications et/ou des temporisations, ladite structure logique combinatoire/séquentielle comprenant une architecture logique numérique réalisant des coefficients pour effectuer lesdites opérations, où ladite architecture logique numérique est une architecture logique numérique selon l'une quelconque des revendications 1 à 4 précédentes.

## FIGURE 1.

### FIR filter

### IIR filter

Figure 1a.

Other Application (Combination, sequential logic minimization)

Any logic comprising of elements/operations shown here

Block (A)

FIR/IIR filter equation

$$Y(z) = X(z) [c(0) + c(1) Z^{-1} + c(2) Z^{-2} + c(3) Z^{-2} + ..... + c(n) Z^{-n}] \qquad ....FIR \ Eq$$

$$Y(z) = X(z) \ \frac{[c(0) + c(1) Z^{-1} + c(2) Z^{-2} + c(3) Z^{-2} + ..... + c(n) Z^{-n}]}{[1 - (b(1) Z^{-1} + b(2) Z^{-2} + b(3) Z^{-2} + ..... + b(m) Z^{-m})]} \qquad ....IIR \ Eq$$

where X(z)-input signal, $Z^{-1} * X(z)$ - delayed signal by one delay, Y(z)-output signal c(0), c(1), c(2).......c(n), b(1), b(2).......b(m) are integer coefficients values.

FIGURE 2.

Unit Delay

$x(nT)$ → [ T ] → $y(nT)$    $y(nT) = x(nT - T)$

Full adder

| A | | Sum |
| B | FA | |
| Cin | | Cout |

Sum = A + B + Cin

Carryout = Cout

Full subtractor

| A(+) | | Diff |
| B(-) | FS | |
| Cin | | Cout |

Diff = A - B - Cin

Borrow-out = Cout

Serial adder

$x_1(nt)$
$x_2(nT)$ → ( SA ) → $y(nT)$    $y(nT) = x_1(nT) + x_2(nT)$

Serial subtractor

$x_1(nt)$
$x_2(nT)$ → ( SS (-) ) → $y(nT)$    $y(nT) = x_1(nT) - x_2(nT)$

Multiplier

m

$x(nT)$ → ( M ) → $y(nT)$    $y(nT) = m * x(nT)$

Delay

Input Frame size = X bits (e.g input is 1010101 or X=7 bits)

To store X bit frame, number of T element used is X or 7 in present case

Serial one bit Input
Frame size (X bits) → [ $Z^{-1}$ ] → Serial one bit Output
Frame size (X bits)

Serial one bit Input            OR
Frame size (X bits) → [ T | T | T | T | T | T | T ] →    Eq $y(n) = x(n-1)$

16

# FIGURE 3.

## Unit Delay

x(nT) (0101011) → D | T | Q → (01010110) → output

clock → CLK

Input frame Input pattern (0101011) is coming serially at x(nT) pin at clock rate specified on clock pin

## Full adder (FA) / Full subtractor (FS)

binary addition/subtraction components is realized using following truth table

| Truth table - Full adder | | | | | Truth table - Full Subtractor | | | | |
|---|---|---|---|---|---|---|---|---|---|
| A | B | Cin | Z | Co | A | B | Cin | Z | Co |
| 0 | 0 | 0 | 0 | 0 | 0 | 0 | 0 | 0 | 0 |
| 0 | 0 | 1 | 1 | 0 | 0 | 0 | 1 | 1 | 1 |
| 0 | 1 | 0 | 1 | 0 | 0 | 1 | 0 | 1 | 1 |
| 0 | 1 | 1 | 0 | 1 | 0 | 1 | 1 | 0 | 1 |
| 1 | 0 | 0 | 1 | 0 | 1 | 0 | 0 | 1 | 0 |
| 1 | 0 | 1 | 0 | 1 | 1 | 0 | 1 | 0 | 0 |
| 1 | 1 | 0 | 0 | 1 | 1 | 1 | 0 | 0 | 0 |
| 1 | 1 | 1 | 1 | 1 | 1 | 1 | 1 | 1 | 1 |

## Serial Adder(SA) / Subtractor (SS)

## Serial Multiplier(M)

m=331 ( integer)

Bit Multiplier Coefficient size in this example is 331 (binary 101001011)

17

# FIGURE 4.

## Implementation I

Input

CLin_n    CLin_2    CLin_1    CLin_0

Block (A)    Coefficient block

c(n) (M)    ...... (M)    c(2) (M)    c(1) (M)    c(0) (M)

CLout_n    CLout_2    CLout_1    CLout_0

Block (E)    $Z^{-1}$ (SA) → $Z^{-1}$ (SA) → $Z^{-1}$ (SA) → $Z^{-1}$ (SA) →

## Realization of coefficient using share-able multiplier (coeff. = 3,11)

Input → | T | T | T |

(SA) → (SA)

Input * 3    Input * 11

## Implementation 2

Block (E)

Input → $Z^{-1}$ → $Z^{-1}$ → $Z^{-1}$ → $Z^{-1}$ → — — — → $Z^{-1}$

CLin_0    CLin_1    CLin_2    CLin_n

c(0) (M)    c(1) (M)    c(2) (M)    c(3) (M)    .... (M)    c(n) (M)

(SA) → (SA) → (SA) → (SA) — — — → (SA) →

Block (A)    Coefficient block

FIGURE 5.

Input

CLin_0  CLin_1  CLin_2  CLin_3  CLin_4  CLin_5  CLin_6

Block (A)

Output

FIGURE 6.

Input

CLin_0  CLin_1  CLin_2  CLin_3  CLin_4  CLin_5  CLin_6

Block (A)

Output

Begin: Using the property of symmetrical coefficient

FIGURE 7.

FIGURE 8.

A) Approx. Number of SA = number of coefficient * max coeff size /2)

B) Flip-flop (T) are not sharable

Approx. Number of flip-flops ~ number of coeff * (max. coefficient size/2)

FIGURE 9.

FIGURE 10.

Approx. Number of serial adders = (number of coefficient
max coeff size /2)
Number of flip-flops(l) = Size of maximum coefficient

FIGURE 11.

FIGURE 12.

FIGURE 13.

MSBs of the result can be got from here.

Figure 14

```
          BIT4              BIT3            BIT2             BIT1            BIT0
  = ( S1 + S3 ) + 2 * ( S2 + S4 + 2 * ( S1 + S2 + S4 + 2 * ( S2 + S3 + S4 + 2 * ( S3 + S4 ) ) ) )
```

| SA(1) | | A1=SA(3) | | A1=SA(3) | | A2=SA(9) | | A2=SA(9) |

SA(5)          SA(7)

T(1)=2 * SA(9)

SA(3)

T(2)=2 * SA(8)

SA(6)

T(3)=2 * SA(6)

SA(4)

T(4)=2 * SA(4)

SA(2)

Output

FIGURE 15